# EUROPÄISCHE PATENTANMELDUNG

(11) **EP 1 211 139 A1**
(43) Veröffentlichungstag der Anmeldung: **05.06.2002**
(21) Anmeldenummer: 01127104.6
(22) Anmeldetag: 15.11.2001
(51) Int. Cl.: B60R 16/02, H02G 3/00

(54) **Kabelbaumanordnung, insbesondere für Fahrzeuge**

(30) Priorität: 01.12.2000 DE 10060070
(71) Anmelder: Webasto Vehicle Systems International GmbH, 82131 Stockdorf (DE)
(72) Erfinder: Klesing, Joachim, 80992 München (DE); Hahn, Ferdinand, 86911 Diessen (DE); Hoffmann, Peter, 94140 Ering (DE)
(74) Vertreter: Wiese, Gerhard

(57) **Zusammenfassung**

Bei einer Kabelbaumanordnung, insbesondere zur Verbindung einzelner Komponenten eines Fahrzeugs, mit einer flexiblen gedruckten Leiterplatte (10), die mindestens eine gedruckte flächige Leiterbahn (12) aufweist, sowie mindestens einem nicht-flächigen Leiter (22, 24, 32, 34), ist der nicht-flächige Leiter mindestens teilweise durch die flexible gedruckte Leiterplatte fixiert.

## Beschreibung

Die vorliegende Erfindung betrifft eine Kabelbaumanordnung, insbesondere zur Verbindung einzelner Komponenten eines Fahrzeugs, mit einer flexiblen gedruckten Leiterplatte (FPC), die mindestens eine gedruckte flächige Leiterbahn aufweist, sowie mindestens einem nicht-flächigen Leiter.

Bei vielen technischen Geräten und insbesondere im Fahrzeugbau muss eine Vielzahl von Komponenten über Stromversorgungs- und Datenleitungen miteinander verbunden werden, wie beispielsweise bei einem Kraftfahrzeug, bei welchem die einzelnen elektrischen Komponenten, wie Lichter, Instrumente, elektrische Antriebe und dergleichen mit dem elektrischen Bordnetz sowie mit geeigneten Schalteinrichtungen verbunden werden müssen.

Um das Verlegen der einzelnen Kabel einfacher zu gestalten, werden mehrere Kabel und Verbindungsleitungen zu einem Kabelbaum zusammengefasst, bei welchem die einzelnen Leiter eine Länge entsprechend ihrer späteren Einbaulage haben und bereits mit entsprechenden Verbindungsmitteln versehen sind. Grundsätzlich gibt es zwei Arten solcher Kabelbäume, nämlich einerseits Kabelbäume, bei welchen mehrere einzeln isolierte Leiter zu einem Bündel zusammengefasst und gegebenenfalls ummantelt sind, sowie andererseits flexible gedruckte Leiterplatten, bei welchen mehrere Leiterbahnen auf eine flexible flache Leiterplatte aufgedruckt sind. Gewöhnlich wird über die gedruckten Leiterbahnen eine Deckschicht aufgebracht, so dass die Leiterbahnen in die gedruckte Leiterplatte integriert sind.

Da die Art des Leiters von den Anforderungen der jeweils zu verbauenden Komponenten abhängt und bei vielen Komponenten sowohl aus Litzen aufgebaute Kabelbäume als auch Kabelbäume mit flexiblen gedruckten Leiterplatten (sogenannten FPC-Kabelbäume) verlegt werden müssen, beispielsweise beim Anschluss eines Autoradios, bei welchem zur Stromversorgung üblicherweise Kupferlitzenkabel verwendet werden, zur Verbindung mit einer Antenne ein Koaxialkabel vorgesehen wird und zur Verbindung des Radios beispielsweise mit einem Navigationssystem ein eine gedruckte flexible Leiterplatte aufweisender Datenleiter vorgesehen wird, und somit nicht alle anzuschließenden Leitungen in einem Kabelbaum, d.h. entweder FPC-Kabelbaum oder Kabelbaum mit nicht-flächigen Leitern wie z.B. Litzen oder Koaxialkabeln, untergebracht werden können, müssen mehrere Kabelbäume einzeln verlegt und fixiert werden.

Es ist eine Aufgabe der vorliegenden Erfindung, eine Kabelbaumanordnung der eingangs genannten Art zu schaffen, mittels welcher sich der Anschluss und die Montage von mit Leitern zu verbindenden Komponenten insbesondere eines Fahrzeugs vereinfachen lassen.

Gemäß der vorliegenden Erfindung wird diese Aufgabe bei einer Kabelbaumanordnung, insbesondere zur Verbindung einzelner Komponenten eines Fahrzeugs, mit einer flexiblen gedruckten Leiterplatte, die mindestens eine gedruckte flächige Leiterbahn aufweist, sowie mit mindestens einem nicht-flächigen Leiter dadurch gelöst, dass der nicht-flächige Leiter mindestens teilweise durch die flexible gedruckte Leiterplatte fixiert, insbesondere in diese eingebettet, ist. Da auf diese Weise nur noch ein gemeinsamer Kabelbaum verlegt und fixiert werden muss, kann auf separate Halterungen für die nicht-flächigen Leiter, bei welchen es sich beispielsweise um Koaxialkabel, isolierte Metalldrähte, Metall-Litzen oder Lichtleiter handeln kann, verzichtet werden, wodurch sich der Montageaufwand wesentlich verringert.

Bevorzugte Ausgestaltungen der Erfindung ergeben sich aus den Unteransprüchen.

Insbesondere kann der nicht-flächige Leiter über nur einen Teil seiner Länge in die flexible gedruckte Leiterplatte integriert sein, wobei dann die flexible gedruckte Leiterplatte Stege zur Integration des nicht-flächigen Leiters sowie zwischen den Stegen Ausnehmungen aufweisen kann. Eine derartige Ausgestaltung der erfindungsgemäßen Kabelbaumanordnung ist in mehrfacher Hinsicht vorteilhaft. Einerseits verringert sich aufgrund der Ausnehmungen das Gewicht des Kabelbaums während sich gleichzeitig die Flexibilität des Kabelbaums erhöht. Andererseits können die Stege bzw. die zwischen den Stegen befindlichen Ausnehmungen zum Fixieren des Kabelbaums, beispielsweise an einer Fahrzeugkarosserie, genutzt werden. So könnte beispielsweise ein mit Stegen versehener Kabelbaum unter Zuhilfenahme eines Kabelbinders, der durch zwei einen Steg begrenzende Ausnehmungen gefädelt ist, fahrzeugfest fixiert werden.

In weiterer Ausgestaltung der Erfindung kann aber auch mindestens ein Teil der Flächenbereiche der flexiblen gedruckten Leiterplatte zwischen den Stegen nur so weit von der Leiterplatte ausgenommen sein, dass aus der Ebene der Leiterplatte herausklappbare Laschen zum Fixieren der Kabelbaumanordnung gebildet werden. Derartige Laschen könnten im einfachsten Fall mit Durchbrüchen versehen sein, um den Kabelbaum beispielsweise mittels Clipsen, die durch die Ausnehmungen sowie durch entsprechend an einer Fahrzeugkarosserie vorgesehene Ausnehmungen eingeführt werden, fahrzeugfest zu verrasten.

Ein bevorzugtes Ausführungsbeispiel der Erfindung wird nachstehend unter Bezugnahme auf die beiliegende Zeichnung im Detail beschrieben, die eine Prinzipskizze einer erfindungsgemäßen Kabelbaumanordnung veranschaulicht.

Im beschriebenen Ausführungsbeispiel wird auf die Montage eines Kabelbaums in einem Fahrzeug Bezug genommen. Es versteht sich, dass sich die Erfindung in gleicher Weise bei jeglichen Geräten und Vorrichtungen verwenden lässt, bei welchen gleichzeitig FPC-Kabel und andere Leiter, wie sie vorliegend als nicht flächige Leiter bezeichnet werden, verlegt werden sollen.

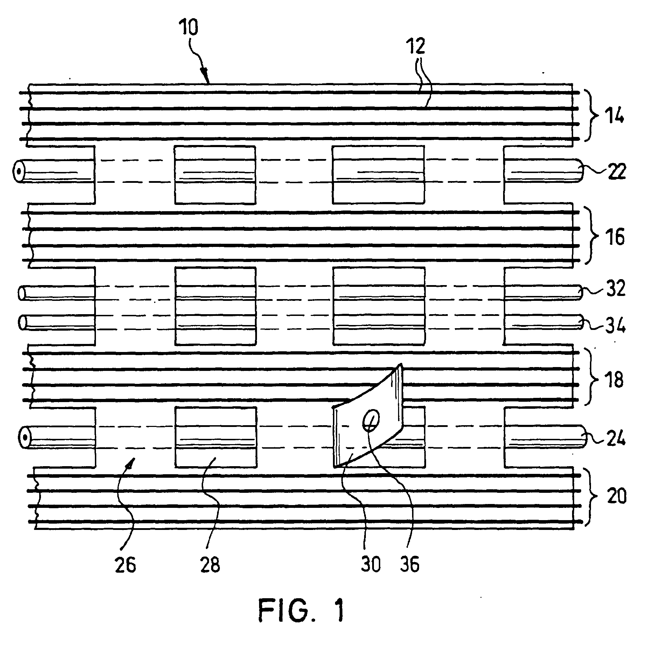

In der als FIG. 1 bezeichneten einzigen Zeichnung ist eine flexible Leiterplatte 10 veranschaulicht, die eine Mehrzahl von flächigen gedruckten Leiterbahnen 12 aufweist. Im gezeigten Ausführungsbeispiel sind hierbei 16 Leiterbahnen 12 vorgesehen, die unter Bildung von vier jeweils vieradrigen Flächenleitern 14, 16, 18 und 20 zusammengefasst sind.

Zwischen den Flächenleitern 14 und 16 sowie zwischen den Flächenleitern 18 und 20 ist jeweils ein Koaxialkabel 22 bzw. 24 angeordnet, die jeweils an Stegen 26 in die flexible Leiterplatte 10 integriert sind. Ein Teil der Flächenbereiche der flexiblen Leiterplatte 10 wurde bei der Ausformung der Leiterplatte freigelassen oder nachträglich entfernt, wie es beispielsweise bei der Ausnehmung 28 veranschaulicht ist, während ein weiterer Teil der Flächenbereiche der Leiterplatte nur so weit von der Leiterplatte ausgenommen ist, dass aus der Ebene der Leiterplatte herausklappbare Laschen gebildet werden, wie es bei 30 veranschaulicht ist. Der Kabelbaum lässt dann sich in einfacher Weise unter Zuhilfenahme der Stege 26 und/oder der Laschen 30 fixieren, beispielsweise indem ein Kabelbinder oder ein ähnliches derartiges Befestigungsmittel durch zwei einen Steg 26 begrenzende Ausnehmungen 28 eingeführt und karosseriefest angebracht wird. Werden Laschen 30 vorgesehen, so können diese mit Durchbrechungen 32 versehen werden, um den von der flexiblen Leiterplatte 10 gebildeten Kabelbaum unter Zuhilfenahme von geeigneten Befestigungsmitteln wie beispielsweise Kabelbindern, Clipsen, Schrauben, Nieten etc., zu fixieren.

Wie gezeigt, können in die einzelnen Stege 26 auch mehrere nicht-flächige Leiter integriert sein, wobei in FIG. 1 die Integration zweier Kupferlitzen 32 und 34 im mittleren Bereich der gedruckten Leiterplatte 10 veranschaulicht ist.

Es versteht sich, dass die Zahl und Anordnung der Stege 26 frei gewählt werden kann. So kann es beispielsweise zweckmäßig sein, den Abstand zwischen zwei Stegen 26 größer zu wählen, wenn in die flexible Leiterplatte 10 ein Koaxialkabel integriert ist und die Leiterplatte 10 zwecks Anordnung derselben in einer Ecke bzw. entlang einer Stufe geknickt werden soll, für das Koaxialkabel hingegen ein größerer Biegeradius erforderlich ist.

Wie es bei Kabelbäumen häufig der Fall ist, können einzelne Leiter oder einzelne Gruppen von Leitern eine unterschiedliche Länge aufweisen. So könnten bei dem in FIG. 1 gezeigten Ausführungsbeispiel insbesondere die einzelnen Flächenleiter 14, 16, 18 und 20 (prinzipiell auch die einzelnen Leiterbahnen innerhalb der Flächenleiter), die Koaxialkabel 22 und 24 und die Kupferlitzen 32 und 34 alle eine individuelle Länge haben und an ihren Enden mit (nicht gezeigten) Verbindungsmitteln, insbesondere Steckern, versehen sein.

Wie bereits erwähnt, lassen sich mit dem vorliegend erläuterten Konzept grundsätzlich jegliche Leiterarten zusammen mit flexiblen gedruckten Schaltungen zu Kabelbäumen integrieren. Als Beispiele für solche Leiter seien insbesondere Metall-Litzen, isolierte Metalldrähte, Koaxialkabel und Lichtleiter genannt.

## Patentansprüche

1. Kabelbaumanordnung, insbesondere zur Verbindung einzelner Komponenten eines Fahrzeugs, mit einer flexiblen gedruckten Leiterplatte (10), die mindestens eine gedruckte flächige Leiterbahn (12) aufweist, sowie mindestens einem nicht-flächigen Leiter (22, 24, 32, 34), **dadurch gekennzeichnet, dass** der nicht-flächige Leiter (22, 24, 32, 34) mindestens teilweise durch die flexible gedruckte Leiterplatte (10) fixiert ist.

2. Kabelbaumanordnung nach Anspruch 1, **dadurch gekennzeichnet, dass** der nicht-flächige Leiter (22, 24, 32, 34) mindestens teilweise in die flexible gedruckte Leiterplatte (10) eingebettet ist.

3. Kabelbaumanordnung nach Anspruch 1 oder 2, **dadurch gekennzeichnet, dass** der nicht-flächige Leiter (22, 24, 32, 34) über nur einen Teil seiner Länge in die flexible gedruckte Leiterplatte (10) integriert ist.

4. Kabelbaumanordnung nach Anspruch 3, **dadurch gekennzeichnet, dass** die flexible gedruckte Leiterplatte (10) Stege (26) zur Integration des nicht-flächigen Leiters (22, 24, 32, 34) aufweist.

5. Kabelbaumanordnung nach Anspruch 4, **dadurch gekennzeichnet, dass** die flexible gedruckte Leiterplatte (10) zwischen den Stegen (26) Ausnehmungen (28) aufweist.

6. Kabelbaumanordnung nach Anspruch 4 oder 5, **dadurch gekennzeichnet, dass** die flexible gedruckte Leiterplatte (10) zwischen den Stegen (26) Haltemittel (30) zum Fixieren der Kabelbaumanordnung aufweist.

7. Kabelbaumanordnung nach Anspruch 6, **dadurch gekennzeichnet, dass** mindestens ein Teil (30) der Flächenbereiche der flexiblen gedruckten Leiterplatte (10) zwischen den Stegen (26) nur soweit von der Leiterplatte (12) ausgenommen ist, dass aus der Ebene der Leiterplatte herausklappbare Laschen (30) zum Fixieren der Kabelbaumanordnung gebildet werden.

8. Kabelbaumanordnung nach einem der vorhergehenden Ansprüche, **dadurch gekennzeichnet, dass** der Leiter (22, 24, 32, 34) ein Koaxialkabel, ein isolierter Metalldraht, eine Metalllitze oder ein Lichtleiter ist.

9. Kabelbaumanordnung nach einem der vorhergehenden Ansprüche, **dadurch gekennzeichnet, dass** eine Mehrzahl von gedruckten flächigen Leiterbahnen (12) vorgesehen ist und mindestens ein nicht-flächiger Leiter (22, 24, 32, 34) zwischen zwei Leiterbahnen angeordnet ist.

10. Kabelbaumanordnung nach einem der vorhergehenden Ansprüche, **dadurch gekennzeichnet, dass** die gedruckten flächigen Leiterbahnen (12) und/oder die nicht-flächigen Leiter (22, 24, 32, 34) eine unterschiedliche Länge haben.
